# EUROPÄISCHE PATENTANMELDUNG

(11) **EP 3 270 668 A1**
(43) Veröffentlichungstag der Anmeldung: **17.01.2018**
(21) Anmeldenummer: 16178950.8
(22) Anmeldetag: 12.07.2016
(51) Int. Cl.: H05K 7/14, H05K 7/20

(54) **GEHÄUSE FÜR EIN INDUSTRIELLES KOMMUNIKATIONSGERÄT UND INDUSTRIELLES KOMMUNIKATIONSGERÄT**

(71) Anmelder: Siemens Aktiengesellschaft, 80333 München (DE)
(72) Erfinder: Schilling, Christoph, 76133 Karlsruhe (DE)

(57) **Zusammenfassung**

Ein Gehäuse für ein industrielles Kommunikationsgerät umfasst eine Öffnungen für zumindest Steckverbindungsbuchsen aufweisende Gehäusefront und eine zumindest eine Öffnung für einen Energieversorgungsanschluss aufweisende Rückwand. Zwischen der Gehäusefront und der Rückwand erstrecken sich zwei Seitenwände. Die beiden Seitenwände sind durch ein Gehäusegrundelement miteinander verbunden. Ein Gehäusedeckel weist eine sich parallel zur Gehäusefront erstreckende Nut auf, deren Tiefe und Breite jeweils zumindest eine halbe Gehäusehöhe beträgt. Zumindest in einem sich senkrecht zur Gehäusefront erstreckenden Abschnitt der Nut sind an den Gehäusedeckel Kühllamellen angeformt, die sich parallel zur Gehäusefront erstrecken. In den Seitenwänden sind zur Nut im Gehäusedeckel kongruenten Aussparungen vorgesehen, wobei durch die Nut und die Aussparungen in den Seitenwänden ein Kühlluftkanal gebildet ist.

## Beschreibung

Industrielle Automatisierungssysteme dienen zur Überwachung, Steuerung und Regelung von technischen Prozessen, insbesondere im Bereich Fertigungs-, Prozess- und Gebäudeautomatisierung, und ermöglichen einen Betrieb von Steuerungseinrichtungen, Sensoren, Maschinen und industriellen Anlagen, der möglichst selbständig und unabhängig von menschlichen Eingriffen erfolgen soll. Eine besondere Bedeutung hat dabei eine Bereitstellung von Überwachungs-, Steuerungs- und Regelungsfunktionen in Echtzeit. Störungen von Kommunikationsverbindungen zwischen industriellen Kommunikationsgeräten, Automatisierungsgeräten oder Rechnereinheiten eines industriellen Automatisierungssystems können zu einer nachteiligen Wiederholung einer Übermittlung einer Dienstanforderung führen. Insbesondere können nicht oder nicht vollständig übermittelte Nachrichten einen Übergang oder Verbleib eines industriellen Automatisierungssystems in einen sicheren Betriebszustand verhindern und zu einem Ausfall einer industriellen Anlage führen. Eine besondere Problematik resultiert in industriellen Automatisierungssystemen aus einem Meldungsverkehr mit verhältnismäßig vielen, aber relativ kurzen in Echtzeit zu übermittelnden Nachrichten.

Aus EP 1 597 950 B1 ist ein robuster Ethernet-Switch bekannt, der ein Gehäuse mit einer Vielzahl von darin ausgebildeten Perforationen zum Kühlen des Ethernet-Switches umfasst. Zur Kühlung des Ethernet-Switches ist ein passives Kühlungssystem ohne Lüfter vorgesehen. Außerdem ist zur Messung der Temperatur des Ethernet-Switches ein Temperatursensor vorgesehen. Außerdem umfasst der Ethernet-Switch Alarmsoftware, die auf den Temperatursensor anspricht und einen Alarm auslöst, wenn die gemessene Temperatur des Ethernet Switch eine bestimmte Grenze überschreitet.

US 2003/135601 A1 betrifft einen Ethernet-Switch für einen Einsatz unter rauen Umgebungsbedingungen, insbesondere in Umspannwerken. Der Ethernet-Switch umfasst eine Kühlvorrichtung mit einem thermoelektrischen Kühlelement, dessen erste Oberfläche thermisch in Kontakt mit einer Komponente im Ethernet-Switch steht. Eine zweite Oberfläche des thermoelektrischen Kühlelements steht thermisch in Kontakt mit einem Wärmeableiter. Dabei überträgt das thermoelektrische Kühlelement in Abhängigkeit von einem in das thermoelektrische Kühlelement eingeprägten Strom Wärme von der ersten Oberfläche zur zweiten Oberfläche. Mittels einer Steuerungseinheit wird der Strom in das thermoelektrische Kühlelement eingeprägt, sobald die Temperatur im Ethernet-Switch einen vorbestimmten Wert überschreitet.

In EP 2 252 137 A2 ein offenes Gehäuse für elektrische Module beschrieben, wobei das Gehäuse eine obere Öffnung und eine untere Öffnung aufweist, die durch Umgebungsluft durchströmt werden können. Das Gehäuse kann eine Vielzahl von Modulen aufnehmen, die jeweils in thermischem Kontakt mit einem Kühlkörper stehende elektrische Komponenten umfassen. Wenn die Module in das Gehäuse eingesetzt sind, kann Umgebungsluft von der unteren Öffnung über die Kühlkörper der Module zur oberen Öffnung strömen, um die Module und die von diesen umfassten elektrischen Komponenten passiv zu kühlen. Die Kühlkörper haben Rippen, die einen Abstand von 9 mm bis 12 mm zueinander und eine Höhe 10 mm bis 20 mm aufweisen. Elektrischen Anschlüssen am Gehäuse sind jeweils codierte Stifte zugeordnet, die einerseits zur Fixierung der Module und andererseits zur Verhinderung einer Bestückung von Steckplätzen des Gehäuses mit einem unzulässigen Modultyp vorgesehen sind. An den Ecken der Module sind Führungsstifte vorgesehen, die zu Führungsöffnungen im Gehäuse passen, so dass die Module sicher im Gehäuse gehalten und Vibrationen vermindert werden.

Werden leistungsstarke industrielle Kommunikationsgeräte direkt aneinander angrenzend in einem Gestell, beispielsweise in einem 19-Zoll-Rack, montiert, können sich die Kommunikationsgeräte derart gegenseitig aufheizen, dass sie nur bei niedrigeren Umgebungstemperaturen eingesetzt werden können. Alternativ zu einem Einsatz bei niedrigeren Umgebungstemperaturen kann beispielsweise ein Steckplatz für ein Kommunikationsgerät zwischen zwei Kommunikationsgeräten in einem Gestell freigelassen werden. Hierdurch werden jedoch grundsätzlich verfügbare Steckplätze nicht optimal ausgenutzt.

Der vorliegenden Erfindung liegt daher die Aufgabe zugrunde, ein Gehäuse für ein industrielles Kommunikationsgerät zu schaffen, das eine kompakte Anordnung mehrerer ein solches Gehäuse umfassender Kommunikationsgeräte in einem Gestell bzw. Rack und eine ausreichende Kühlung der Kommunikationsgeräten auch bei erhöhten Umgebungstemperaturen ermöglicht, und ein entsprechendes industrielles Kommunikationsgerät anzugeben.

Diese Aufgabe wird erfindungsgemäß durch ein Gehäuse für ein industrielles Kommunikationsgerät mit den in Anspruch 1 angegebenen Merkmalen und durch ein industrielles Kommunikationsgerät mit den in Anspruch 15 angegebenen Merkmalen gelöst. Vorteilhafte Weiterbildungen der vorliegenden Erfindung sind in den abhängigen Ansprüchen angegeben.

Das erfindungsgemäße Gehäuse für ein industrielles Kommunikationsgerät umfasst eine Öffnungen für zumindest Steckverbindungsbuchsen aufweisenden Gehäusefront sowie eine zumindest eine Öffnung für einen Energieversorgungsanschluss aufweisenden Rückwand. Zusätzlich weist das Gehäuse zwei sich zwischen der Gehäusefront und der Rückwand erstreckende Seitenwände und ein die beiden Seitenwände miteinander verbindendes Gehäusegrundelement auf. Außerdem ist ein Gehäusedeckel mit einer sich parallel zur Gehäusefront erstreckenden Nut vorgesehen, deren Tiefe und Breite jeweils zumindest eine halbe Gehäusehöhe beträgt. Zumindest in einem sich senkrecht zur Gehäusefront erstreckenden Abschnitt der Nut sind an den Gehäusedeckel angeformte Kühllamellen angeordnet, die sich parallel zur Gehäusefront erstrecken. Darüber hinaus umfasst das Gehäuse zur Nut im Gehäusedeckel kongruente Aussparungen in den Seitenwänden. Dabei ist durch die Nut und die Aussparungen in den Seitenwänden ein Kühlluftkanal gebildet. Ferner sind in einem dem Gehäusegrundelement zugewandten, durch die Nut gebildeten Abschnitt des Gehäusedeckels mehrere Befestigungselemente für eine Platine des Kommunikationsgeräts vorgesehen.

Mittels des durch die Nut und die Aussparungen in den Seitenwänden gebildeten Kühlluftkanals kann erfindungsgemäß ein thermisch isolierendes Luftpolster zwischen zwei in einem Gehäuse bzw. Rack direkt aneinander angrenzend gestapelten Kommunikationsgeräten geschaffen werden. Dieses thermisch isolierende Luftpolster kann vorteilhafterweise noch weiter vergrößert werden, wenn der Gehäusedeckel in einem an die Gehäusefront angrenzenden Abschnitt und in einem an die Rückwand angrenzenden Abschnitt jeweils einen durchgehenden randartigen Vorsprung aufweist. Außerdem ermöglicht der durch die Nut und die Aussparungen in den Seitenwänden gebildete Kühlluftkanal bei - beispielsweise mittels eines Lüfters - bewegter Umgebungsluft eine verbesserte Wärmfortleitung aus dem Gehäuse. Aufgrund einer durch die Nut bedingten profilierten Gestaltung des Gehäuses können bei Betrieb heiß werdende Bauteile des Kommunikationsgeräts gut an einen durch die Kühllamellen gebildeten, vorzugsweise von Umgebungsluft umströmten Kühlkörper angebunden werden. Außerdem ermöglichen die profilierte Gestaltung des Gehäuses und eine Befestigung der Platine des Kommunikationsgeräts an dem durch die Nut gebildeten Abschnitt des Gehäusedeckels eine gute mechanische Stabilisierung der Platine.

Die profilierte Gestaltung des Gehäuses kann dahingehend weitergebildet werden, dass zwischen der Gehäusefront und der Nut eine Aufnahme für mit der Platine des Kommunikationsgeräts verbundene Steckverbindungsbuchsen gebildet ist und bei dem zwischen der Rückwand und der Nut eine Aufnahme für ein Netzteil des Kommunikationsgeräts gebildet ist. Auf diese Weise können platzbeanspruchende Komponenten oder Bauteile vorteilhaft im Gehäuse untergebracht werden.

Entsprechend einer bevorzugten Ausgestaltung der vorliegenden Erfindung ist der Gehäusedeckel durch ein Aluminium-Strangpressteil gebildet. Durch einen werkstoffbedingt hohen Wärmleitwert wird eine zusätzlich verbesserte Wärmfortleitung aus dem Gehäuse erzielt. Eine weitere Verbesserung der Wärmefortleitung lässt sich realisieren, wenn die Seitenwände seitliche senkrecht zum Gehäusegrundelement durchlässige Konvektionskörper umfassen.

Die Rückwand ist vorzugweise einstückig an den Gehäusedeckel angeformt. Darüber hinaus bilden die Gehäusefront, die Seitewände und das Gehäusegrundelement eine Einheit, die mit dem Gehäusedeckel verschraubbar ist. Dies ermöglicht eine schnelle Montage. Vorteilhafterweise sind die Seitenwände einstückig an das Gehäusegrundelement angeformt.

Entsprechend einer weiteren Ausgestaltung des erfindungsgemäßen Gehäuses weisen die Gehäusefront oder die Seitenwände Befestigungselemente für eine Montage des Gehäuses in einem Gestell bzw. Rack auf. Die Befestigungselemente können beispielsweise Bohrungen in der Gehäusefront oder in frontseitig abgekröpften Abschnitten der Seitenwände sein.

Vorteilhafterweise umfasst auch die Rückwand Befestigungselemente für die Platine des Kommunikationsgeräts. Dabei weisen die Befestigungselemente der Rückwand Kontaktflächen für die Platine des Kommunikationsgeräts auf. Die Befestigungselemente der Rückwand können beispielsweise durch Vorsprünge an der Rückwand gebildet sein. Sowohl die Befestigungselemente am Gehäusedeckel als auch die Befestigungselemente an der Rückwand können Gewindebohrungen oder Gewindestifte für die Platine des Kommunikationsgeräts umfassen.

Das Gehäusegrundelement kann insbesondere eine Bodenplatte sein. In diesem Fall ist der Gehäusedeckel an einer Gehäuseoberseite angeordnet. Alternativ dazu kann das Gehäusegrundelement an einer Gehäuseoberseite angeordnet sein. In diesem Fall ist der Gehäusedeckel an einer Gehäuseunterseite angeordnet.

Das erfindungsgemäße industrielle Kommunikationsgerät weist mehrere Sende- und Empfangseinheiten, denen jeweils eine Steckverbindungsbuchse zugeordnet ist, ein Koppelelement, durch das die Sende- und Empfangseinheiten selektiv schaltbar miteinander verbindbar sind, und eine Platine auf, auf der die Sende- und Empfangseinheiten und das Koppelelement angeordnet sind. Die Platine ist von einem Gehäuse umfasst, das entsprechend vorangehenden Ausführungen ausgestaltet ist.

Entsprechend einer vorteilhaften Ausgestaltung des erfindungsgemäßen Kommunikationsgeräts ist das Koppelelement ein Backplane-Switch oder ein Hochleistungsbussystem, und das Kommunikationsgerät ist in einem Gestell direkt angrenzend an zumindest ein hinsichtlich seines Gehäuses im wesentlichen identisch ausgestaltetes Kommunikationsgerät montierbar. Das Kommunikationsgerät kann insbesondere ein Switch sein.

Die vorliegende Erfindung wird nachfolgend an einem Ausführungsbeispiel anhand der Zeichnung näher erläutert. Es zeigt
- Figur 1: eine Explosionsdarstellung eines Switches mit einem erfindungsgemäßen Gehäuse,
- Figur 2: eine Schnittdarstellung des Switches gemäß Figur 1.

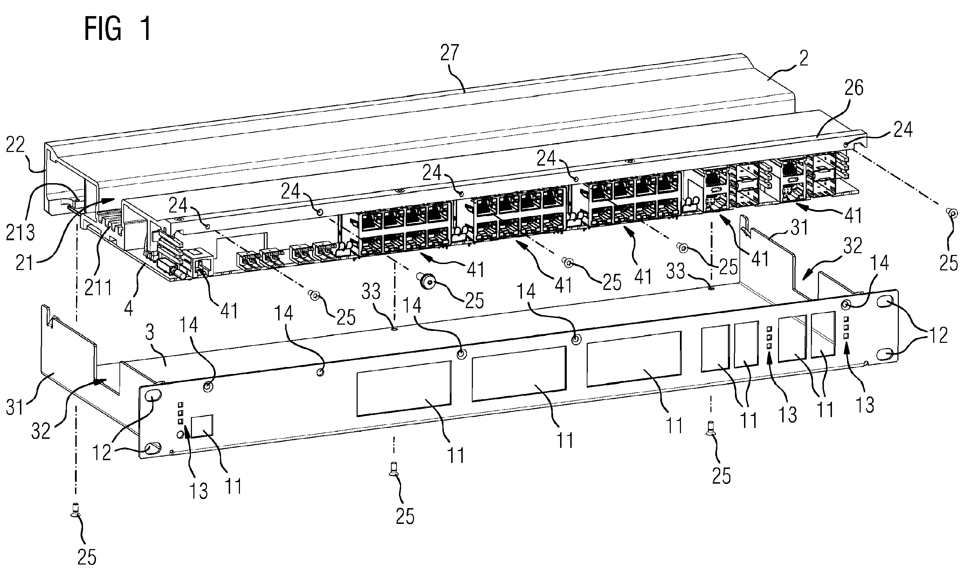

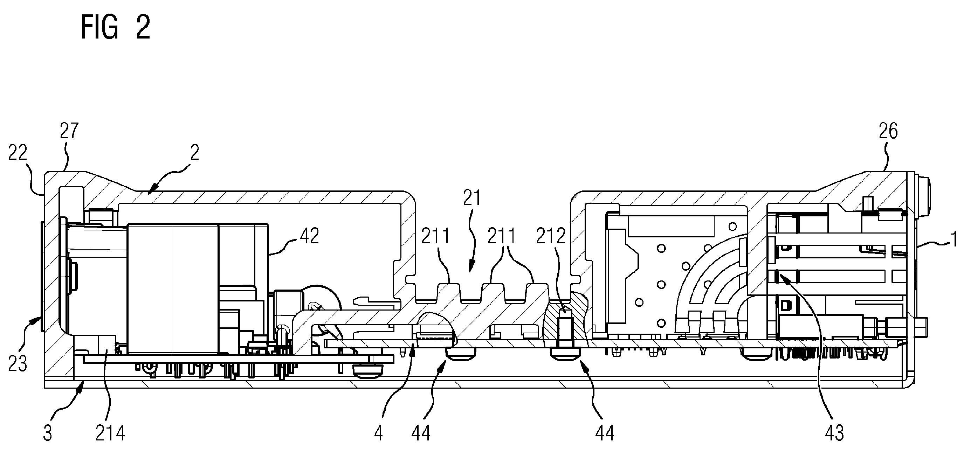

Der in Figur 1 dargestellte Switch umfasst eine Platine 4, auf der mehrere Sende- und Empfangseinheiten, denen jeweils Steckverbindungsbuchse 41 zugeordnet ist, und ein Backplane-Switch angeordnet sind. Durch den Backplane-Switch sind die Sende- und Empfangseinheiten selektiv schaltbar miteinander verbindbar. Die Platine 4 ist in einem Gehäuse montiert, das eine Gehäusefront 1 mit Öffnungen 11 für die Steckverbindungsbuchsen 41 aufweist. Zusätzlich umfasst Gehäusefront 1 Öffnungen 13 für Lichtleiter 43, die mit lichtemittierenden Bauelementen auf der Platine 4 verbunden sind (siehe auch Figur 2). Gegenüber der Gehäusefront 1 weist das Gehäuse eine Rückwand 22 auf, die einstückig an einen Gehäusedeckel 2 angeformt ist, der im vorliegenden Ausführungsbeispiel an einer Gehäuseoberseite angeordnet und durch ein Aluminium-Strangpressteil gebildet ist.

Entsprechend Figur 2 weist die einstückig an den Gehäusedeckel 2 angeformte Rückwand 22 eine Öffnung 23 für einen Energieversorgungsanschluss auf. Der Gehäusedeckel 2 umfasst zudem Aufnahmen für die Lichtleiter 43.

Zwischen der Gehäusefront 1 und der Rückwand 22 erstrecken sich zwei Seitenwände 31, die einstückig an eine Bodenplatte 3 aus Blech angeformt sind, wobei die Bodenplatte 3 die beiden Seitenwände 31 miteinander verbindet. Die Gehäusefront 1, die Seitewände 31 und die Bodenplatte 3 bilden eine Einheit, die mit dem Gehäusedeckel 2 verschraubbar ist. Hierzu umfasst der Gehäusedeckel 2 mehrere Gewindebohrungen 24 für Befestigungsschrauben 25, deren Gewinde und Schaft durch Bohrungen 14, 33 an der Gehäusefront 1 bzw. an der Bodenplatte 3 geführt werden.

Der Gehäusedeckel 2 weist eine sich parallel zur Gehäusefront 1 erstreckende Nut 21 auf, deren Tiefe und Breite jeweils zumindest eine halbe Gehäusehöhe beträgt. In einem sich senkrecht zur Gehäusefront 1 erstreckenden Abschnitt der Nut 21 sind an den Gehäusedeckel 2 Kühllamellen 211 angeformt, die sich parallel zur Gehäusefront 1 erstrecken. In den Seitenwänden 31 sind zur Nut 21 im Gehäusedeckel 2 kongruente Aussparungen 32 vorgesehen, so dass durch die Nut 21 und die Aussparungen 32 in den Seitenwänden 31 ein durchgehender Kühlluftkanal gebildet ist. Aufgrund dieses Kühlluftkanals kann ein Switch in einem Rack direkt angrenzend an einen Switch mit identisch ausgestaltetem Gehäuse montiert werden.

Während zwischen der Gehäusefront 1 und der Nut 31 am Gehäusedeckel 2 eine Aufnahme für die mit der Platine 4 verbundenen Steckverbindungsbuchsen 41 gebildet ist, besteht zwischen der Rückwand 22 und der Nut 21 eine Aufnahme für ein Netzteil 42 des Switches. Zur Vergrößerung eines thermisch isolierenden Luftpolsters zwischen zwei in einem Rack direkt aneinander angrenzend montierten Switches weist der Gehäusedeckel 2 in einem an die Gehäusefront 1 angrenzenden Abschnitt 26 und in einem an die Rückwand 22 angrenzenden Abschnitt 27 jeweils einen durchgehenden randartigen Vorsprung auf.

In einem der Bodenplatte 3 zugewandten, durch die Nut 21 gebildeten Abschnitt des Gehäusedeckels 2 sind Gewindebohrungen 212 als Befestigungselemente für die Platine 4 vorgesehen. In diese Gewindebohrungen 212 werden Befestigungsschrauben 44 zur Montage der Platine 4 am Gehäusedeckel 2 eingeführt. Somit kann die Platine 4 thermisch direkt an den Gehäusedeckel 2 mit den Kühllamellen 211 angebunden werden. Vorteilhafterweise sind wärmekritische Bauteile in diesem Bereich auf der Platine 4 angeordnet. Auch die Rückwand 22 weist Gewindebohrungen 213 zur Befestigung der Platine 4 auf. Dabei sind diese Gewindebohrungen 213 in Vorsprüngen 214 an der Rückwand 22 vorgesehen. Die Vorsprünge 214 bilden neben dem der Bodenplatte 3 zugewandten, durch die Nut 21 gebildeten Abschnitt des Gehäusedeckels 2 Kontaktflächen für die Platine.

Im vorliegenden Ausführungsbeispiel weist die Gehäusefront 1 in über die Seitenwände 31 hinausragenden Außenbereichen Bohrungen 12 als Befestigungselemente für eine Montage des Gehäuses in einem Rack auf. Somit kann das Gehäuse an einem Rack angeschraubt werden. Grundsätzlich könnten die Bohrungen 12 auch in frontseitig abgekröpften Abschnitten der Seitenwände 31 vorgesehen sein.

Eine profilierte Gestaltung des Gehäusedeckels 2 kann auch dazu genutzt werden, eine elektrische bzw. thermische Kontaktierung zwischen ausgewählten Abschnitten auf der Platine 4 bzw. dort angeordneten Bauteilen und dem Gehäusedeckel 2 herzustellen. Hierzu kann der Gehäusedeckel 2 hinsichtlich seines Profils in einfacher Weise an eine Kontur eines zu kontaktierenden Bauteils angepasst werden.

## Patentansprüche

1. Gehäuse für ein industrielles Kommunikationsgerät mit
- einer Öffnungen (11) für zumindest Steckverbindungsbuchsen aufweisenden Gehäusefront (1),
- einer zumindest eine Öffnung (23) für einen Energieversorgungsanschluss aufweisenden Rückwand (22),
- zwei sich zwischen der Gehäusefront (1) und der Rückwand (22) erstreckenden Seitenwänden(31),
- einem die beiden Seitenwände (31) miteinander verbindenden Gehäusegrundelement (3),
- einem Gehäusedeckel (2) mit einer sich parallel zur Gehäusefront (1) erstreckenden Nut (21), deren Tiefe und Breite jeweils zumindest eine halbe Gehäusehöhe beträgt,
- zumindest in einem sich senkrecht zur Gehäusefront (1) erstreckenden Abschnitt der Nut (21) an den Gehäusedeckel (2) angeformten Kühllamellen (211), die sich parallel zur Gehäusefront (1) erstrecken,
- zur Nut (21) im Gehäusedeckel (2) kongruenten Aussparungen (32) in den Seitenwänden (31), wobei durch die Nut (21) und die Aussparungen (32) in den Seitenwänden (31) ein Kühlluftkanal gebildet ist,
- mehreren in einem dem Gehäusegrundelement (3) zugewandten, durch die Nut (21) gebildeten Abschnitt des Gehäusedeckels (2) vorgesehenen Befestigungselementen (212) für eine Platine (4) des Kommunikationsgeräts.

2. Gehäuse nach Anspruch 1,
bei dem zwischen der Gehäusefront (1) und der Nut (21) eine Aufnahme für mit der Platine (4) des Kommunikationsgeräts verbundene Steckverbindungsbuchsen (41) gebildet ist und bei dem zwischen der Rückwand (22) und der Nut (21) eine Aufnahme für ein Netzteil (42) des Kommunikationsgeräts gebildet ist.

3. Gehäuse nach einem der Ansprüche 1 oder 2,
bei dem der Gehäusedeckel durch ein Aluminium-Strangpressteil gebildet ist.

4. Gehäuse nach einem der Ansprüche 1 bis 3,
bei dem der Gehäusedeckel (2) in einem an die Gehäusefront (1) angrenzenden Abschnitt (26) und in einem an die Rückwand (22) angrenzenden Abschnitt (27) jeweils einen durchgehenden randartigen Vorsprung aufweist.

5. Gehäuse nach einem der Ansprüche 1 bis 4,
bei dem die Rückwand einstückig an den Gehäusedeckel angeformt ist.

6. Gehäuse nach Anspruch 5,
bei dem die Gehäusefront, die Seitewände und das Gehäusegrundelement eine Einheit bilden, die mit dem Gehäusedeckel verschraubbar ist.

7. Gehäuse nach einem der Ansprüche 1 bis 6,
bei dem die Seitenwände einstückig an das Gehäusegrundelement angeformt sind.

8. Gehäuse nach einem der Ansprüche 1 bis 7,
bei dem die Seitenwände seitliche senkrecht zum Gehäusegrundelement durchlässige Konvektionskörper umfassen.

9. Gehäuse nach einem der Ansprüche 1 bis 8,
bei dem die Gehäusefront (1) oder die Seitenwände (31) Befestigungselemente (12) für eine Montage des Gehäuses in einem Gestell aufweisen.

10. Gehäuse nach Anspruch 9,
bei dem die Befestigungselemente Bohrungen in der Gehäusefront oder in frontseitig abgekröpften Abschnitten der Seitenwände sind.

11. Gehäuse nach einem der Ansprüche 1 bis 10,
bei dem die Rückwand (22) Befestigungselemente (213) für die Platine (4) des Kommunikationsgeräts aufweist, wobei die Befestigungselemente (213) der Rückwand (22) Kontaktflächen für die Platine (4) des Kommunikationsgeräts umfassen.

12. Gehäuse nach einem der Ansprüche 1 bis 11,
bei dem die Befestigungselemente für die Platine des Kommunikationsgeräts Gewindebohrungen oder Gewindestifte umfassen.

13. Gehäuse nach einem der Ansprüche 1 bis 12,
bei dem das Gehäusegrundelement eine Bodenplatte ist und bei dem der Gehäusedeckel an einer Gehäuseoberseite angeordnet ist.

14. Gehäuse nach einem der Ansprüche 1 bis 12,
bei dem das Gehäusegrundelement an einer Gehäuseoberseite angeordnet ist und bei dem der Gehäusedeckel an einer Gehäuseunterseite angeordnet ist.

15. Industrielles Kommunikationsgerät mit
- mehreren Sende- und Empfangseinheiten, denen jeweils eine Steckverbindungsbuchse zugeordnet ist,
- einem Koppelelement, durch das die Sende- und Empfangseinheiten selektiv schaltbar miteinander verbindbar sind,
- einer Platine, auf der die Sende- und Empfangseinheiten und das Koppelelement angeordnet sind,
- einem die Platine umfassenden Gehäuse, das nach einem der Ansprüche 1-14 ausgestaltet ist.

16. Kommunikationsgerät nach Anspruch 15,
bei dem das Koppelelement ein Backplane-Switch oder ein Hochleistungsbussystem ist und bei dem das Kommunikationsgerät in einem Gestell direkt angrenzend an zumindest ein hinsichtlich seines Gehäuses im wesentlichen identisch ausgestaltetes Kommunikationsgerät montierbar ist.
